(19)

**Europäisches Patentamt**
**European Patent Office**
**Office européen des brevets**

(11) **EP 2 017 899 A1**

(12) **EUROPEAN PATENT APPLICATION**
published in accordance with Art. 153(4) EPC

(43) Date of publication:
**21.01.2009 Bulletin 2009/04**

(21) Application number: **07742297.0**

(22) Date of filing: **24.04.2007**

(51) Int Cl.:
***H01L 33/00*** *(2006.01)*

(86) International application number:
**PCT/JP2007/058862**

(87) International publication number:
**WO 2007/123239 (01.11.2007 Gazette 2007/44)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **24.04.2006 JP 2006119668**

(71) Applicant: **Asahi Glass Company, Limited**
**Chiyoda-ku**
**Tokyo 100-8405 (JP)**

(72) Inventors:
• **NAKAMURA, Nobuhiro**
**Chiyoda-ku, Tokyo 100-8405 (JP)**
• **MATSUMOTO, Syuji**
**Chiyoda-ku, Tokyo 100-8405 (JP)**

(74) Representative: **Rocke, Carsten**
**Müller-Boré & Partner**
**Grafinger Strasse 2**
**81671 München (DE)**

(54) **LIGHT EMITTING DEVICE**

(57)     The present invention provides a light-emitting device realizing high directivity without using a cavity, which minimizes wire-breakage deformation of electrodes and generation of bubbles.

The light-emitting device has a wiring board, a LED electrically connected with the wiring board, and a glass covering the LED. Entirety of the glass is substantially spherical, and the LED is embedded in a part of the glass. Then, a curved surface of the glass preferably contact with side faces of the LED, and the LED is preferably a polygonal semiconductor chip having a rotational center in a front view.

F i g.2

**Description**

TECHNICAL FIELD

The present invention relates to a light-emitting device, more specifically, to a light-emitting device comprising a light-emitting element covered with glass.

BACKGROUND ART

Currently, illumination devices employing white light emitting diodes (hereinafter referred to as LED) as light-emitting elements, are becoming to be practically used. White LEDs used for illumination have merits that 1) power consumption and running cost of white LEDs are less than those of incandescent lamps or fluorescent lamps, 2) lifetime of white LEDs is long and their replacement works can be saved, 3) downsizing is possible, and 4) white LEDs do not employ harmful substances such as mercury employed in fluorescent lamps.

A white LED usually has a structure that a LED is sealed with a resin. For example, in a case of typical one chip type white LED, a LED having an InGaN layer formed by adding In into GaN as a light-emitting layer, is sealed with a resin containing a YAG fluorescent material. When an electric current flows through the LED, the LED emits blue light. Then, a part of the blue light excites the YAG fluorescent material, and the fluorescent material emits yellow light. Since the blue light and the yellow light are complementary colors from each other, a mixture of these colors is recognized as white color by human eyes.

However, a LED sealed with a resin has such problems that a moisture penetrates into the resin in long time operation and prevents operation of the LED, or light emitted from the LED discolors the resin to deteriorate light transmittance of the resin.

Further, a LED can be used at higher environmental temperature and higher power input as the thermal resistance from an assembly board to a light-emitting portion is lower and its durable temperature is higher. Accordingly, the thermal resistance and the heat resistance are key features for achieving high power output of LED. However, when a resin is employed for sealing a LED, there is a problem that since the heat resistance of resin is low, it is not suitable for use with high power output. For example, in a case of epoxy resin, it is yellowed at a temperature of at least 130°C.

To cope with these problems, a LED sealed with a low melting point glass is disclosed (refer to e.g. Patent Documents 1 and 2).

Patent Document 1 discloses a LED lamp wherein a LED element die-bonded to the bottom in the center of concave portion of a reflective bowl, the LED element is connected with a lead portion via a wire bonding portion, and they are sealed with a low-melting-point glass by using e.g. a hot mold.

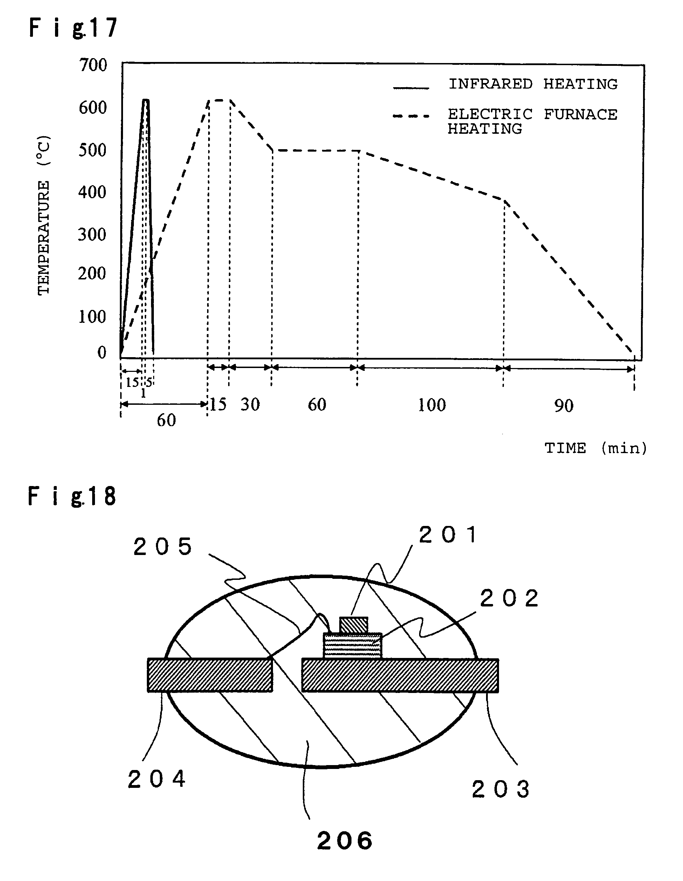

Further, Patent Document 2 discloses a technique of sealing a GaN with a glass by using a mold-press method and an electric furnace. Fig. 18 shows a cross-sectional view of a light-emitting device as an example of such a technique. A light-emitting diode chip 201 mounted on a submount 202 is disposed on a lead 203. Further, the light-emitting diode chip 201 is connected with a lead 204 by a bonding wire 205. Then, the light-emitting diode chip 201 is sealed with a sealing member 206 together with the bonding wire 205. The sealing member 206 is a low-melting-point glass, and by softening the low-melting-point glass by heating, the light-emitting diode chip 201, the bonding wire 205 and a circuit around these members are sealed.

By sealing a LED with a low-melting-point glass, it is possible to reduce moisture-absorption property through the sealing member or deterioration of light-transmittance due to discoloring of sealing member, and to improve heat resistance.

Here, "a low-melting-point glass" means a glass material having a deformation point lower than that of typical glass. Commonly, expansion of a glass material is evaluated according to the distance of movement of a detecting portion of a measurement apparatus that is pushed by the glass material when the glass material expands in a uniaxial direction. The deformation point is a temperature at which the glass material becomes too soft to push the detecting portion.

Patent Document 1: JP-A-8-102553
Patent Document 2: WO2004/082036

DISCLOSURE OF THE INVENTION

PROBLEMS TO BE SOLVED BY THE INVENTION

However, in the techniques of Patent Documents 1 and 2, not only a LED, but also a wire bonding portion is sealed with glass. For example, in the technique of Patent Document 2 shown in Fig. 18, e.g. the light-emitting diode chip 201 and the bonding wire 205 are all covered with glass. For this reason, it is concerned that the bonding wire is broken when the device is produced.

Further, in the method shown in Patent Documents 1 and 2of sealing with glass by using a mold, there is a risk that the electrode portion of the LED is deformed by a pressure at the time of molding.

Further, when a LED is sealed with glass, air tends to be contained in the glass and bubbles tend to be formed in the glass. For this reason, there has been a problem that extraction efficiency of light emitted from the LED is deteriorated.

Further, in Fig. 18, the sealing member 206 has a oblate shape. This is considered to be because the low-melting-point glass has a characteristic that its viscosity radically changes according to the temperature. When the sealing member 206 has such a shape, directivity of light emitted from the light-emitting diode chip 201 is lowered. On the other hand, in applications such as light sources to be employed for optical fibers or projectors, there are strong demands for LEDs having high directivity.

In order to increase directivity of light, a construction is considerable, in which a LED is disposed in a cavity so that light from the LED is reflected by the cavity and the light can be extracted to the front. In this case, the cavity is usually made of a ceramic material such as alumina. However, providing such a cavity causes cost up of entire light-emitting device. Further, since a ceramics has a certain degree of light-transmittance, a part of light emitted from a LED is transmitted without being reflected.

The present invention has been made considering these problems. Namely, it is an object of the present invention to provide a light-emitting device achieving high directivity without using a cavity, which can minimize breakage of wire, deformation of electrodes and generation of bubbles.

Other objects and merits of the present invention will become clear from the following descriptions.

MEANS OF SOLVING THE PROBLEMS

A first aspect of the present invention is characterized by a light-emitting device comprising a wiring board, a light-emitting element electrically connected with the wiring board and a glass covering the light-emitting element, wherein entirety of the glass is substantially spherical, the light-emitting element is embedded in a part of the glass, and a curved surface of the glass contacts with a side face of the light-emitting element.

A second aspect of the present invention is characterized by a light-emitting device comprising a wiring board, a light-emitting element electrically connected with the wiring board and a glass covering the light-emitting element, wherein the glass has a portion having a curved surface and a flat portion in terms of surface shape, a surface of the light-emitting element facing to the wiring board and the flat portion of the glass substantially share the same plane, and provided that a length from the center to the end of the opposite plane facing to the wiring board is designated as "a" and the length from the end of the plane to the outer periphery of the flat portion is designated as "b", a relation

$$0 < (b/a) \leq 0.2$$

is satisfied.

In the second aspect of the present invention, it is preferred that when the refractive index of the glass is at most 1.6, a relation

$$0 < (b/a) \leq 0.1$$

is satisfied.

Further, in the second aspect of the present invention, it is preferred that the curved surface is a part of a spherical surface.

In the first and second aspect of the present invention, the light-emitting element may be a polygonal semiconductor chip having a rotation center in a front view.

In the first and second aspect of the present invention, the light-emitting element may be any one of a LED and a semiconductor laser.

In the first and second aspect of the present invention, it is preferred that the glass contains $TeO_2$, $B_2O_3$ and ZnO as main components.

EFFECTS OF THE INVENTION

According to the first aspect of the present invention, since a light-emitting element is embedded in a part of a glass whose entirety is substantially spherical, and a curved surface of the glass contacts with a side face of the light-emitting element, it is possible to realize high directivity without providing a cavity. Further, it is also possible to achieve a light-emitting device wherein wire-breakage, deformation of electrodes and generation of bubbles are minimized.

According to the second aspect of the present invention, a plane of the light-emitting element facing to the wiring board substantially shares the same plane with a flat portion of the glass, and provided that the length from the center to the end of the plane facing to the wiring board is designated as "a" and the length from the end of the plane to the outer periphery of the flat portion of the glass is designated as "b", a relation that

$$0 < (b/a) \leqq 0.2$$

is satisfied, and accordingly, high directivity is realized without providing a cavity. Further, it is also possible to achieve a light-emitting device wherein wire-breakage, deformation of electrodes and generation of bubbles are minimized.

BRIEF DESCRIPTION OF THE DRAWINGS

Fig. 1: An explanation view of characteristics of light emitted from a spherical surface.
Fig. 2: An example of a cross-sectional view of a light-emitting device in an embodiment of the present invention.
Fig. 3: A view showing the light-emitting device of Fig. 2 observed from a direction 45° shifted from that of Fig. 2.
Fig. 4: A partial cross-sectional view of the light-emitting device in this embodiment.
Fig. 5: A plane view of the light-emitting device of Fig. 4 observed from LED side.
Fig. 6: A view showing the relation between (b/a) and an angle θ' in this embodiment.
Fig. 7: A view showing evaluation result of angle dependence of emitted light in this embodiment.
Fig. 8: A cross-sectional view of a glass sealing a LED along its principal axis in this embodiment.
Fig. 9: A view showing the relation between the refractive index of glass and focal length.
Fig. 10: A view explaining a production method of the light-emitting device in this embodiment.
Fig. 11: A view explaining a production method of the light-emitting device in this embodiment.
Fig. 12: A view explaining a production method of the light-emitting device in this embodiment.
Fig. 13: A view explaining a production method of the light-emitting device in this embodiment.
Fig. 14: An example of plan view showing a LED applicable to this embodiment.
Fig. 15: A cross-sectional view of the LED of Fig. 14 along A-A' line.
Fig. 16: Another example of cross-sectional view of a LED applicable to this embodiment.
Fig. 17: A view showing temperature profiles of heatings by infrared rays and electric furnace.
Fig. 18: A cross-sectional view of a conventional light-emitting device.

EXPLANATION OF NUMERALS

1: Light-emitting device
2, 12, 15: LED
3, 11, 13, 16': Glass
4, 17: Wiring board
5, 18: Wiring
6, 19: Bump
7: Light
8: Center
16: Glass member
20: Sealing resin

BEST MODE FOR CARRYING OUT THE INVENTION

First, characteristic of light emitted from spherical surface is described.

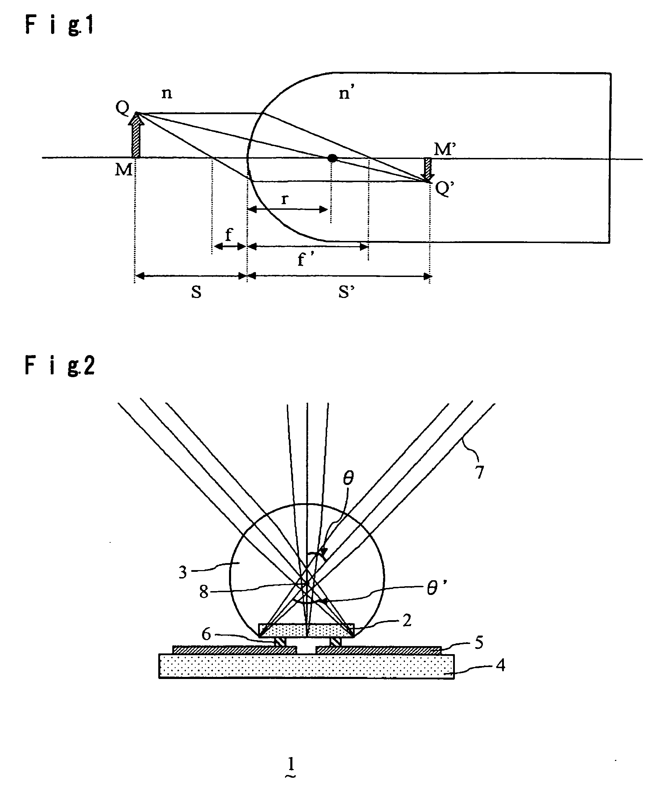

In Fig. 1, a medium of refractive index n contacts with a medium of refractive index n' having a spherical surface. In this mode (hereinafter referred to as this embodiment), the medium of refractive index n corresponds to air and the medium of refractive index n' corresponds to a glass.

In the medium of refractive index n', considering that a portion forming the spherical surface is a part of a sphere, the radius of the sphere is designated as r. Further, the medium of refractive index n' is considered as a lens, and light is assumed to pass through the medium and output from the spherical surface into the medium of refractive index n. In this case, the focal length in the refractive index n' side is designated as f', and the focal length in the refractive index n side is designated as f. When an image MQ of an object M'Q' disposed at a position a distance S' from the spherical surface in the medium of refractive index n', is formed at a position a distance S from the spherical surface in the medium of refractive index n, the relation of formula (1) is satisfied.

$$(n/S) + (n'/S') = (n'-n)/r \qquad (1)$$

In formula (1), when n=1 and n'=2, the relation of formula (2) is satisfied.

$$(1/S) + (2/S') = 1/r \qquad (2)$$

Further, in formula (2), when S'=2r, S=∞ is satisfied. This means that light emitted from a point light source disposed on a surface of the spherical medium, transmitted and output from the spherical surface becomes parallel light.

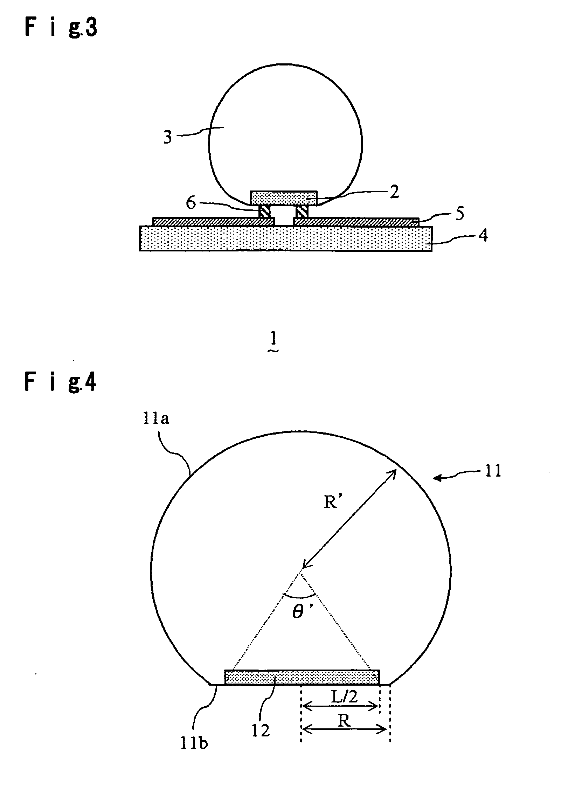

Fig. 2 is an example of cross-sectional view of a light-emitting device 1 of this embodiment. Further, Fig. 3 is a cross-sectional view of the light-emitting device 1 of Fig. 2 observed from a direction 45° shifted from the direction of Fig. 2. As shown in these Figs, a LED 2 is a semiconductor chip having a rectangular shape in a front view, and the LED 2 is electrically connected with wirings 5 on a wiring board 4 via bumps 6. Further, the light-emitting device has a construction that the LED 2 is embedded in a part of a glass 3 whose entirety is substantially spherical. Then, a curved surface of the glass 3 contacts with a side face of the LED 2.

In the light-emitting device 1 of Figs. 2 and 3, a face of the LED 2 facing to the wiring board 4, that is, an electrode face has a rectangular shape. Then, Fig. 2 is a cross-sectional view along a diagonal line of the electrode face, and Fig. 3 is a cross-sectional view along a line passing through the center of the electrode face and at an angle of 45° to the diagonal line. Then the electrode face is considered so that each apex of its rectangular shape contacts with the curved face of the glass 3. Accordingly, in Fig. 3, a lower part of the glass 3 has slightly oblate shape as compared with that of Fig. 2.

LED 2 is provided with a light-emitting layer (not shown) in parallel with the electrode face, and light can be extracted mainly from a plane opposite to the electrode face.

Light 7 from LED 2 is, as schematically shown in Fig. 2, transmitted through the glass 3 and output into the air. As described above, light emitted from a point light source disposed on a surface of a spherical medium, is transmitted through the medium, output from a spherical surface, and transformed into parallel light. Here, the position of the light-emitting layer of LED 2 is considered to be substantially equal to the position of the electrode face. Further, in Fig. 2, since the shape of glass 3 can be assumed to be substantially spherical, light output from a contact point between LED 2 and the glass 3, namely, from the vicinity of an apex of the electrode face, is considered as light from a point light source disposed on a surface of the spherical medium, then, light transmitted through the glass 3 is considered to be parallel light. Further, at this time, the output angle θ is considered to be substantially equal to 1/2 of an angle θ' between light beams output from the vicinity of apexes of the electrode face and passing through the center 8 of the glass 3.

Then, a case where the curved face of the glass does not contact with the side face of LED, in other words, a case where each apex of the electrode face of the LED does not contact with the curved face of the glass, is considered.

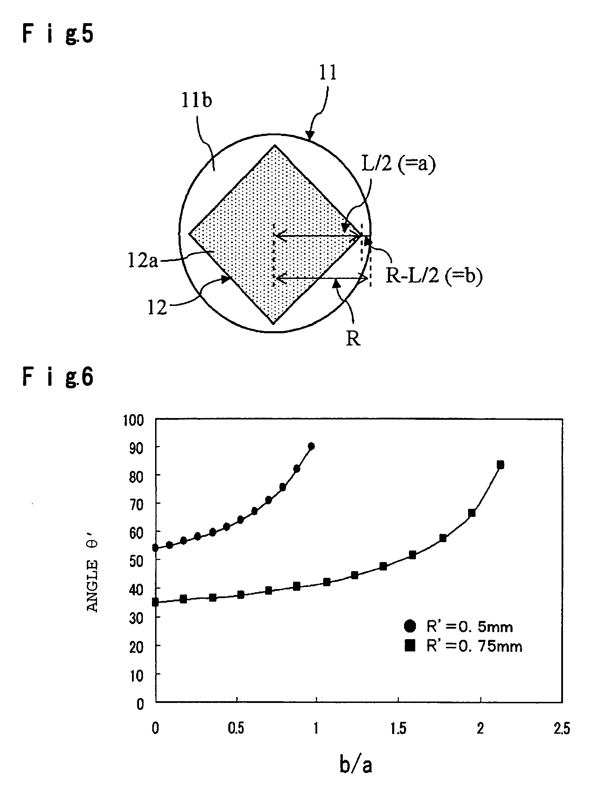

Fig. 4 is a partial cross-sectional view of the light-emitting device, which shows a structure that a LED is covered with a glass. Further, Fig. 5 is a plan view of the light-emitting device of Fig. 4 observed from the LED side. Here, to facilitate understanding, Fig. 5 only shows a flat portion 11b of the glass 11 to be described later, and a spherical surface portion 11a is omitted.

As shown in Figs. 4 and 5, the glass 11 has a spherical surface portion 11a and a flat portion 11b. Then, a LED 12 is located at a flat portion 11b, and each apex of the electrode face 12a is disposed more inside from the spherical surface of the glass 11. In this example, since the outer shape of the flat portion 11b can be regarded as circular, provided that the radius of this portion is designated as R and the length of a diagonal line of the electrode face 12a is designated as L, the distance from an apex of the electrode face 12a to the spherical surface of the glass 11 is represented by (R-L/2). Then, in this specification, (L/2) is designated as a and (R-L/2) is designated as b, so that the ratio of a portion of the glass 11a protruding from the electrode face 12a is represented by (b/a). When (b/a) is 0, there is no flat portion 11b and the construction becomes one corresponding to Figs. 2 and 3. Namely, the structure is such that entirety of the glass has a substantially spherical shape, and a LED is embedded in a part of it, and further, a spherical surface portion of the glass contacts with side faces of the LED.

Fig. 6 shows the relation between (b/a) and an angle θ' (=2θ) of light output from the vicinity of an apex of the electrode face 12a and passing through the center of the glass 11, that is obtained by calculation. Here, values of the angle θ' are specifically obtainable by the following manner.

As described above, L being the length of a diagonal line of the electrode face of the LED, can be obtained by actual measurement. Further, with respect to the glass sealing the LED, its spherical surface portion is considered to be a part of a sphere, and when the radius of the sphere is designated as R', also the R' can be obtained by actual measurement. Then, first of all, by multiplying (L/2) by an appropriate (b/a) value and adding (L/2) to the product, the radius R of the flat portion of the glass is obtained. Subsequently, the distance from the center of the glass to the electrode face is obtained from the radius R and the radius R'. From the distance obtained and the radius R', a value of (θ'/2) can be obtained, and by multiplying the value by 2, the angle θ' can be obtained. Here, in this example, the electrode face is assumed to be a square of 320 $\mu$m, and L/2 is 226 $\mu$m. Further, the above calculation was made with respect to a case of the radius R'=0.5 mm and a case of R'=0.75 mm.

When (b/a) is not 0, an apex of the electrode face is not on the spherical surface, and accordingly, strictly speaking, light output from the vicinity of the apex does not become parallel light after it passes the spherical surface. Accordingly, even when (b/a) is equal to 0, from the structure shown in Fig. 2, 1/2 of the angle θ' can be regarded to be substantially equal to the output angle θ, but as (b/a) increases, the difference between these values increase. However, since the output angle θ increases as the angle θ' increases, by studying the relation between the value of (b/a) and the angle θ', the relation between the value of (b/a) and the output angle θ can be presumed.

In Fig. 6, as the value of (b/a) increases, the angle θ' also increases. This is because in Fig. 5, as the distance b from an apex of the electrode face 12a to the spherical surface of the glass 11 increases, the distance from the center 8 (refer to Fig. 2) of the glass 11 to the LED 12 decreases. Accordingly, it is considered that as the value of (b/a) increases, the output angle θ increases and the directivity of light output from the LED 12 decreases.

Further, in Fig. 6, the angle θ' when (b/a) is 0 increases as the value of the radius R' decreases. Accordingly, it is considered that as the glass 11 sealing the LED 12 is smaller, the output angle θ becomes larger. On the other hand, as the value of the radius R' is larger, change of the angle 2θ by the change of (b/a) is smaller. From these results, decrease of directivity by the increase of the distance b from the apex of the electrodes face 12a to the spherical surface of the glass 11, is considered to decrease as the glass 11 sealing the LED 12 becomes larger.

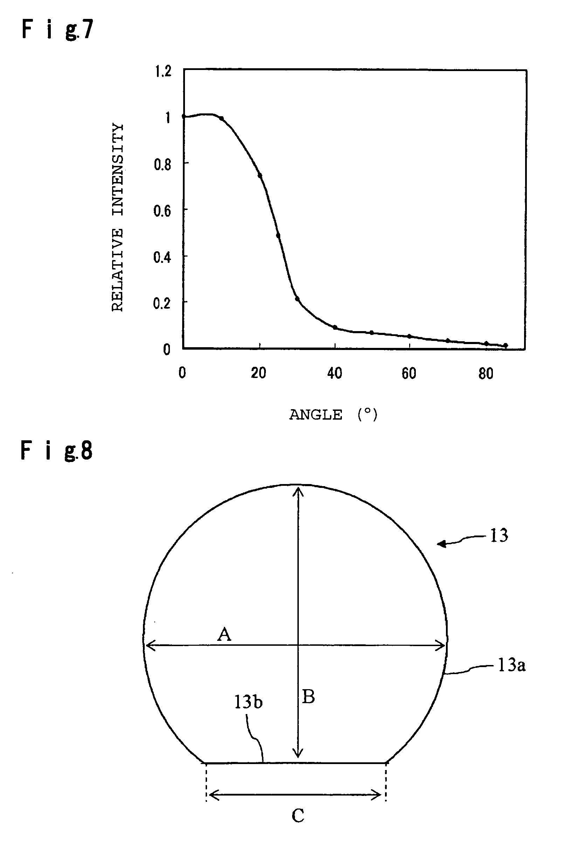

Fig. 7 shows an evaluation result of angle dependence of output light obtained by actually preparing a light-emitting device. Here, the LED used has a dimension L/2=226 $\mu$m and a main emission peak wavelength of 460 nm. Further, the radius R of the glass sealing the LED was 0.23 mm, the radius R' was 0.5 mm and the refractive index at a wavelength X=460 nm was 1.98. Further, in this emission device, the value of (b/a) was 0.

The output angle θ means an angle at which the relative intensity becomes 1/2 based on the output light component at an angle showing the highest intensity, that is usually in the vicinity of 0°, and accordingly, the output angle θ is estimated to be about 24° from Fig. 7. Meanwhile, in Fig. 6, the angle θ' corresponding to a radius R' of 0.5 mm is about 53° and an output angle θ derived from this value is 26.5°. Accordingly, it is understandable that the output angle θ is not significantly different from the value obtained by actual measurement.

EXAMPLES

The light-emitting device of Fig. 7 was prepared in the following manner. Here, this is an example, and the process for producing the light-emitting device in an embodiment of the present invention is not limited to this process.

PREPARATION OF WIRING BOARD

As a substrate, an alumina substrate having a purity of 99.6% and a thickness of 1 mm was employed. Then, a gold paste for wiring was prepared. Specifically, gold (80 wt%), a first glass component (2 wt%) and an organic varnish (18 wt%) were blended, kneaded for 1 hour in a percelain mortar, and kneading was carried out three times by employing three rolls to produce a gold paste.

As the gold, a fine particle powder of spherical shape having an average particle size of 2 $\mu$m was employed. Further, as the first glass component, a flake-shaped glass powder having an average particle size of 1 $\mu$m was employed, which is composed of $SiO_2$ (44.65 mol%), $B_2O_3$ (13.13 mol%), $ZnO$ (18.44 mol%), $Li_2O$ (6.58 mol%), $Na_2O$ (7.06 mol%),

$K_2O$ (0.71 mol%) , $TiO_2$ (3.15 mol%), $Bi_2O_3$ (5.28 mol%) and $CeO_2$ (1.0 mol%). Here, the softening point of the first glass component was 550°C. Further, as the organic varnish, one prepared by dissolving an ethyl cellulose resin of polymerization degree 7 was dissolved in $\alpha$-terpineol so that the concentration of the resin was 20 wt%, was employed.

Then, a wiring pattern was formed by printing the surface of the alumina substrate with the gold paste. Thereafter, the alumina substrate was subjected to a heating treatment at 120°C for 10 minutes, and baked at 800°C for 30 minutes to prepare gold wirings on the alumina substrate.

LED

E1C60-0B011-03 (product name) manufactured by Toyoda Gosei Co., Ltd. was employed. The electrode face of this LED is a square of 320 $\mu$m, and its L/2=226 $\mu$m.

BONDING

First of all, total two bumps were formed on electrodes of the LED. Specifically, by using a manual wire bonder (product name 7700D) manufactured by WEST·BOND Inc., gold bumps were formed from a gold wire of 25 $\mu$m in diameter (SGH-25 (product name) manufactured by Sumitomo Metal Mining Co., Ltd.). The gold bumps formed each has a diameter of 100 $\mu$m and a height of 25 $\mu$m.

Then, the electrodes provided in the LED and gold wirings were bonded via gold bumps. At this time, in order to make the LED parallel with the substrate, the bonding was carried out while a predetermined pressure was applied. Specifically, by using a flip chip bonder (product name MOA-500) manufactured by Hisol Inc., the LED was flip-chip mounted on the alumina substrate. The diameter of gold bumps after bonding was about 100 $\mu$m, and their height was about 15 to 20 $\mu$m.

GLASS SEALING

As a glass member, one composed of $TeO_2$ (45.0 mol%), $TiO_2$ (1.0 mol%), $GeO_2$ (5.0 mol%), $B_2O_3$ (18.0 mol%), $Ga_2O_3$ (6.0 mol%), $Bi_2O_3$ (3.0 mol%), ZnO (15 mol%), $Y_2O_3$ (0.5 mol%), $La_2O_3$ (0.5 mol%), $Gd_2O_3$ (3.0 mol%) and $Ta_2O_5$ (3.0 mol%), was employed.

Then, the glass member was fabricated into a block shape having an appropriate size, and placed on the LED that was flip-chip mounted, and they were subjected to a heating treatment.

As a heating apparatus, an infrared heating apparatus IVF298W (product name) manufactured by Thermo Riko Co., Ltd. was employed. An infrared lamp of this apparatus has a radiation wavelength band of from 600 to 1,100 nm, and a maximum radiation intensity in the vicinity of 900 nm. Here, the present inventors have proposed in their Japanese application 2006-111089 a structure and a production process of a glass-sealed light-emission element. Further, they proposed in Japanese application 2006-072612 a glass-melting method by employing an infrared condensation heating apparatus. Any of these heating methods can be applied to the present invention.

In a chamber of the heating apparatus, aluminum titanate ($Al_2O_3 \cdot TiO_2$) (product name: Lotec TM) manufactured by Asahi Glass Ceramics Co., Ltd. having a diameter of 20 mm was placed as an infrared-absorbing member, the wiring board bonded with the LED was placed on the infrared-absorbing member, and the above glass member was placed on the LED. Here, the temperature was measured by contacting the ceramics with a thermocouple.

Irradiation of infrared rays was made at 2 kW from the infrared-absorbing member side. The temperature profile was such that the temperature was raised from a room temperature to 630°C in 15 min, it was maintained at 630°C for about 30 sec to 1 min 50 sec, and dropped to a room temperature in 5 min.

The light-emitting device prepared above is evaluated as follows.

Directivity of light emitted from the LED is evaluated with respect to output angle θ. The output angle θ correlates to an angle θ' between light beams output from the vicinity of apexes of the electrode face of LED and passing the center of glass. Here, provided that the ratio of protrusion of glass from the electrode face is represented by (b/a), the angle θ' increases as the value of (b/a) increases. Namely, by changing the value of (b/a), the angle θ' can be changed, and as a result, the output angle θ can be changed. This means that the directivity can be controlled by the value of (b/a). For example, when the value of (b/a) is increases, the output angle θ increases, and accordingly, the directivity of light emitted from the LED decreases. Accordingly, only by changing the value of (b/a), it becomes possible to provide a light-emitting device having a required output angle θ. In this case, when the value of (b/a) is 0, namely, when the device has a structure that the curved surface of glass contacts with side faces of the LED, particularly high directivity can be achieved. Further, when (b/a)≦0.2, change of directivity can be reduced, and sufficient production margin can be maintained.

From the viewpoint of increasing directivity of light, the value of (b/a) is preferably small, and the value is the most preferably 0. On the other hand, from Fig. 6, it is understandable that the ratio of change of the angle θ increases as the value of (b/a) increases. When (b/a)≦0.2, in both of cases of R'=0.5 mm and R'=0.75 mm, change of the angle θ can be suppressed to within a range of at most 3°. Accordingly, from the viewpoint of increasing directivity of light, it is preferred to make (b/a)≦0.2, it is the most preferred to make (b/a)=0.

Here, in the above example, an LED having an electrode face of 320 $\mu$m square and L/2=226 $\mu$m is employed, but this embodiment is not limited thereto. Also in a case of LED having an electrode face of different size, from the viewpoint of increasing directivity of light, it is preferred to satisfy (b/a)≦0.2, it is the most preferably satisfy (b/a)=0.

Further, in the above example, the shape of the electrode face is rectangular, but this embodiment is not limited thereto. Namely, when the structure is such that a LED is embedded in a part of a glass whose entirety is substantially spherical, and a curved face of the glass contacts with side faces of the LED, then, the effect of the present invention can be obtained. Further, when the glass contains a portion having a curved surface and a flat portion, and an electrode face of LED substantially shares the same plane with the flat portion of the glass, and further, the length from the center to the end of the electrode face corresponds to the above "a", and the length from the end of the electrode face to the outer periphery of the flat portion of the glass corresponds to the above "b", then, a relation:

$$0 < (b/a) \leq 0.2$$

is satisfied and the effect of the present invention can be obtained. In this case, when (b/a) is 0, the LED is embedded in a part of the glass whose entirety is substantially spherical, and such a structure corresponds to a structure in which a curved face of the glass contact with side faces of the LED.

Here, from the viewpoint of increasing directivity, it is preferred that the optical axis of LED agrees with a rotational axis of the glass. For this reason, the electrode face of LED is preferably polygonal having a rotation center in a front view. For example, the shape of electrode face may, for example, be a square, a rectangle, a parallelogram or a rhomb.

For example, when the shape of electrode face is circular, it is possible to consider as follows. Namely, when the radius of the flat portion of glass is R and the diameter of the electrode face is L, as described above, the directivity of light can be discussed by using the value of (b/a). In this case, when (b/a)=0 is satisfied, entirety of outer periphery of the electrode face contact with the spherical face of glass.

By the way, the directivity of output light increases as the shape of glass becomes close to a sphere. Considering this point, the shape of glass is described below.

Fig. 8 is a cross-sectional view along a principal axis of a glass 13 sealing a LED. In this Figure, the surface shape of the glass 13 is constituted by a curved surface portion 13a and a flat portion 13b. Further, the shape of the glass 13 is defined by three parameters that are a dimension A along a horizontal principal axis of the curved surface portion 13a, a dimension B along its vertical principal axis, and a dimension C of the flat portion 13b. Here, among the dimensions A, B and C, a relation

$$A > B > C$$

is satisfied.

Here, in the light-emitting device of this embodiment, since an electrode face of LED is present at the flat portion 13b, the above horizontal direction means a horizontal direction in relation to the electrode face. Further, since the LED is disposed on the wiring board so that the electrode face of the LED is down side of the LED, "horizontal direction in relation to electrode face" is, in other words, "horizontal direction in relation to wiring board". The same relation is also satisfied with respect to vertical direction.

From the viewpoint of increasing directivity, the curved face portion is preferably a part of a spherical face or an elliptical body face, particularly, it is preferred to be a part of spherical face. In other words, the glass 12 preferably has a shape as close to a sphere as possible.

Table 1 shows the relation between dimensions A, B and C and oblateness (B/r).

Here, r is the radius of a spherical body when the curved surface portion 13a is considered to be a part of the spherical body.

In the example of Table 1, each glass sample was prepared as follows. First of all, a glass member composed of $TeO_2$ (45.0 mol%), $TiO_2$ (1.0 mol%), $GeO_2$ (5.0 mol%), $B_2O_3$ (18.0 mol%), $Ga_2O_3$ (6.0 mol%), $Bi_2O_3$ (3.0 mol%), ZnO (15 mol%), $Y_2O_3$ (0.5 mol%), $La_2O_3$ (0.5 mol%), $Gd_2O_3$ (3.0 mol%) and $Ta_2O_5$ (3.0 mol%) was prepared. Then, on a flat plate on which a mold-lubricant layer such as boron nitride or carbon was formed, the glass member was placed. Thereafter, the glass member was heated to be melted and cooled to form a glass including a portion having a curved surface and a flat portion in terms of surface shape. Here, since the "flat portion" is formed at a portion where the glass member and the mold-lubricant member are contact, the shape of the flat portion is substantially circular, and the surface was generally traces the surface shape of the mold-lubricant layer.

TABLE 1

| Glass | A (mm) | B (mm) | C (mm) | Oblateness (B/r) |
|---|---|---|---|---|
| 1 | 1.421 | 1.255 | 0.725 | 0.950 |
| 2 | 1.412 | 1.266 | 0.665 | 0.953 |
| 3 | 1.419 | 1.236 | 0.870 | 0.973 |
| 4 | 0.997 | 0.900 | 0.555 | 0.986 |
| 5 | 0.993 | 0.901 | 0.505 | 0.975 |
| 6 | 0.992 | 0.913 | 0.495 | 0.986 |
| 7 | 0.988 | 0.917 | 0.410 | 0.972 |
| 8 | 0.714 | 0.706 | 0.260 | 1.024 |
| 9 | 0.719 | 0.704 | 0.220 | 1.003 |
| 10 | 0.718 | 0.688 | 0.260 | 0.992 |

It is understandable from Table 1 that as the dimension A decreases, the oblateness (B/r) becomes close to 1. Namely, as the volume of glass member employed is smaller, the shape becomes more close to pure sphere and thus, it becomes possible to form a glass having a spherical surface satisfying the above formulae (1) and (2). Namely, it becomes possible to make optical design of the light-emitting device easy. Specifically, it is preferred to satisfy $A \leqq 1.5$ mm, more preferably $A \leqq 1.0$ mm.

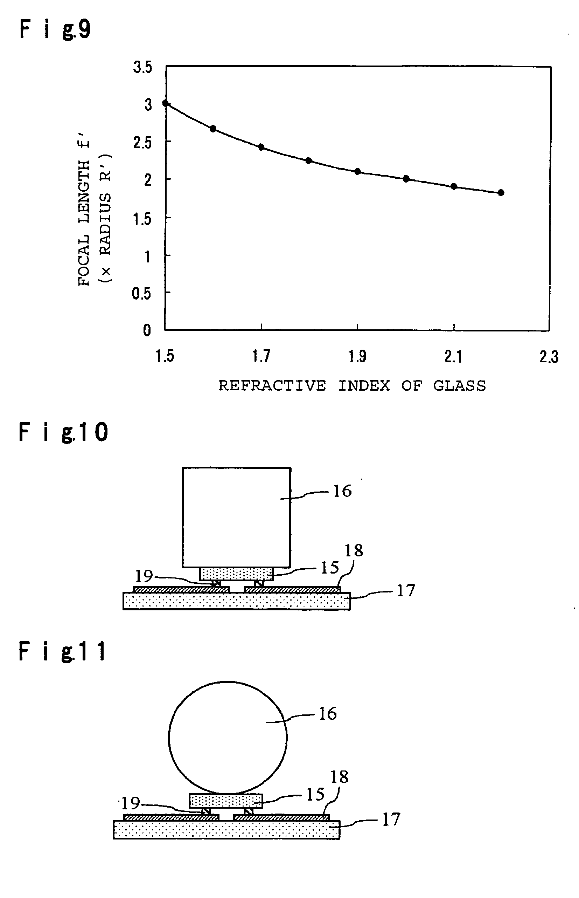

Further, from the viewpoint of increasing directivity, the focal length is preferably short. Fig. 9 shows the relation between refractive index of glass and focal length. Vertical axis represents a value obtained by multiplying the focal length by a radius R'. Here, R' is the radius of a sphere when a curved surface portion of the glass is considered to be a part of the sphere. Further, the focal length corresponds to f' of Fig. 1.

As understandable from Fig. 9, the focal length decreases as the refractive index of glass increases. Accordingly, from the viewpoint of increasing directivity, the refractive index of the glass is preferably high. On the other hand, in a case of low refractive index glass, it is preferred to reduce a value (b/a) showing the relation of protrusion of glass from the electrode face. Specifically, in a case of glass having a refractive index of at most 1.6, it is preferred that $(b/a) \leqq 0.1$.

Thus, by decreasing the value of (b/a), it is possible to increase the directivity of light emitted from LED. Further, when the size of glass is constant, the directivity increases as the shape becomes close to a sphere. Meanwhile, as the size of glass is smaller, its shape becomes close to a sphere, and it becomes possible to form a glass having a spherical surface satisfying the above formulae (1) and (2). Namely, it becomes possible to make optical design of light-emitting device easy. Then, according to the light-emitting device of this embodiment shown in Fig. 2, it is possible to realize high directivity without requiring a cavity. Accordingly, it becomes possible to constitute a light-emitting device suitable for applications such as light sources for optical fibers or projectors.

Further, in the light-emitting device 1 of Fig. 2, a LED 2 and wires 5 are electrically connected via bumps 6. Namely, the apparatus does not have a construction that a wire-bonding portion is sealed with glass as in Patent Document 1 or 2. Accordingly, it becomes possible to avoid a risk of occurrence of wire breakage at a time of producing a device.

Further, in the light-emitting apparatus 1 of Fig. 2, it is also possible to minimize bubbles formed in the glass 3. This point is described in detail as follows.

In order to cover an LED mounted on a wiring board with glass, first of all, it is necessary to soften a glass member by heating. The softened glass flows downwardly by the gravity, and when the glass member contacts with the wiring board, an air is enclosed between the wiring board and the glass member. Then, when the glass member is cooled in this state, a bubble is formed in the glass. This is a mechanism of forming a bubble in the glass caused by air captured in the glass at the time of sealing an LED with glass.

On the other hand, in the light-emitting apparatus of Fig. 2, the glass 3 does not contact with the wiring board 4. Accordingly, since air is not enclosed between these members, it is possible to prevent bubbles from forming in the glass 3.

Here, in the light-emitting device 1 of Fig. 2, the LED 2 is embedded in a part of the glass 3 and a curved surface of the glass 3 contacts with a side face of the light-emitting element 2, but the effect of the present invention is obtainable by a structure other than this. Namely, when the glass has a portion having a curved surface and a flat portion in terms of surface shape, and the structure is that the electrode face of LED substantially shares the same plane with the flat portion of glass, and further, provided that the length from the center of the electrode face to the end is designated as "a", and the length from the end to the outer periphery of the flat portion of glass is designated as "b", a relation

$$0 < (b/a) \leq 0.2$$

is satisfied, then, the displacement from the angle θ' in the structure of Fig. 2 can be reduced.

Here, in this case, when the refractive index of glass is at most 1.6, it is preferred that $0<(b/a)\leq0.1$.

In Fig. 2, the curved face of the glass 3 contact with side faces of LED 2, but does not contact with the electrode face of LED 2. However, since high directivity can be obtained when (b/a) is 0, namely, when each apex of rectangle forming the electrode face contacts with a curved face of the glass 3, and so long as the structure satisfies this requirement, the glass 3 may wrap around to the electrode face. This point is applied to a case where the electrode face has a shape other than a rectangle.

Further, in the light-emitting device of this embodiment, it is possible to cover a LED with glass without employing a mold. Accordingly, it is also possible to avoid defects such as occurrence of deformation of electrode portions of LED due to the pressure at a time of molding.

With reference to Figs. 10 to 13, the process for producing the light-emitting device of this embodiment is described.

First of all, a glass member 16 for covering a LED 15 is prepared.

The glass member 16 employed has a softening point of at most 500°C, preferably at most 490°C, an average linear expansion coefficient of from $65\times10^{-7}/°C$ to $95\times10^{-7}/°C$ in a temperature range of from 50°C to 300°C, an internal transmittance of at least 80%, preferably at least 85%, more preferably at least 90%, further preferably at least 93% per 1 mm thick for light of 405 nm wavelength, and a refractive index of at least 1.7, preferably at least 1.9, more preferably at least 2.1 for the above light. Particularly, one having a softening point of at most 500°C, an average linear expansion coefficient of from $65\times10^{-7}/°C$ to $95\times10^{-7}/°C$ in a temperature range of from 50°C to 300°C, an internal transmittance of at least 80% per 1 mm thick for light of 405 nm wavelength, and a refractive index of at least 1.8 for this light, is preferred. When such a glass is employed, since the difference from LED 15 in thermal expansion coefficient is small, it is possible to reduce residual stress and to prevent generation of a crack in a glass after sealing. Further, since such a glass has high transmittance and high refractive index, it is possible to cover the LED 15 without deteriorating extraction efficiency of light emitted from the LED 15.

The glass member 16 of this embodiment is preferably one containing $TeO_2$, $B_2O_3$ and ZnO, and among such glass members, particularly preferably one containing at least 10 mol%, preferably from 40 mol% to 54 mol% of $TeO_2$. By increasing the content of $TeO_2$, it becomes possible to increase refractive index.

Specifically, one in which the total content of $TeO_2$ and $GeO_2$ is from 42 mol% to 58 mol%, the total content of $B_2O_3$, $Ga_2O_3$ and $Bi_2O_3$ is from 15 mol% to 35 mol%, the content of ZnO is from 3 mol% to 20 mol%, the total content of $Y_2O_3$, $La_2O_3$, $Gd_2O_3$ and $Ta_2O_5$ is from 1 mol% to 15 mol%, and the total content of $TeO_2$ and $B_2O_3$ is at most 75 mol%, may be employed.

Among these, particularly one in which the content of $TeO_2$ is from 40 mol% to 53 mol%, the content of $GeO_2$ is from 0 mol% to 10 mol%, the content of $B_2O_3$ is from 5 mol% to 30 mol%, the content of $Ga_2O_3$ is from 0 mol% to 10 mol%, the content of $Bi_2O_3$ is from 0 mol% to 10 mol%, the content of ZnO is from 3 mol% to 20 mol%, the content of $Y_2O_3$ is from 0 mol% to 3 mol%, the content of $La_2O_3$ is from 0 mol% to 3 mol%, the content of $Gd_2O_3$ is from 0 mol% to 7 mol%, and the content of $Ta_2O_5$ is from 0 mol% to 5 mol%, is preferably employed.

For example, a glass member 16 employed may be composed of $TeO_2$ (45.0 mol%), $TiO_2$ (1.0 mol%), $GeO_2$ (5.0 mol%), $B_2O_3$ (18.0 mol%), $Ga_2O_3$ (6.0 mol%), $Bi_2O_3$ (3.0 mol%), ZnO (15 mol%), $Y_2O_3$ (0.5 mol%), $La_2O_3$ (0.5 mol%), $Gd_2O_3$ (3.0 mol%) and $Ta_2O_5$ (3.0 mol%) . This composition contains no alkali metal, it has a relatively low softening point (e.g. about 490°C) and it has an average linear expansion coefficient of about $86\times10^{-7}/°C$. Accordingly, it is close to the average linear expansion coefficient ($68\times10^{-7}/°C$ in parallel with C axis, $52\times10^{-7}/°C$ perpendicularly to C axis) of a sapphire substrate commonly used for LED. Further, since the glass member has a high refractive index of 2.01 at a wavelength 405 nm, such a property increases extraction efficiency of emission light from LED 15, and improves directivity of light.

The glass member 16 may contain a fluorescent material. For example, when a fluorescent material emitting yellow light is added to the glass member, blue light emitted from the LED 15 is mixed with yellow light emitted from the fluorescent material excited by a part of the blue light, to produce white light.

The glass member 16 preferably contains substantially no lead from the viewpoint of environmental issue. Further, from the viewpoint of preventing deterioration of electrical property of LED 15, the glass member 16 preferably contains substantially no alkali.

Then, the glass member 16 is formed into a shape capable of being placed on the LED 15. For example, it is preferred to fabricate the glass member 16 into a block shape or a flake shape. Further, a large glass block may be fragmented to obtain a fragment. Here, from the viewpoint of reducing bubbles formed at a time of melting, a surface of the glass member is preferably formed to have a mirror surface. For example, front and rear surfaces of a glass piece cut out into a predetermined size may be subjected to an optical polishing, and the glass piece may be further precisely cut into a desired size to obtain a block-shaped glass to be used as the glass member.

The amount of glass member 16 required for covering the LED 15 is an amount capable of covering a portion of LED 15 from which light is extracted, namely a portion other than the electrode face, with a thickness of at least several times of wavelength of visible light, specifically, with a thickness of at least 2 $\mu$m.

Then, a LED 15 to be covered with the glass member 16 is prepared. Here, the LED 15 is assumed to be mounted to a wiring board 17.

Here, in this embodiment, a LED before it is mounted may be covered with glass and then the LED may be mounted on a wiring board. However, in this case, when the LED is covered with glass, the LED may get into the glass and the electrode face and the flat portion of glass may not share the same plane. Specifically, the electrode face may be disposed higher by the height of bumps. However, since the height of bumps is usually from about 20 to 50 $\mu$m, the directivity of light is considered to be equivalent to that of a case of covering a LED mounted on a wiring board.

As the LED 15, one that is not deteriorated by a heat treatment at the time of sealing the LED 15 with the glass member 16 is employed. Since one having a large band gap usually has high heat resistance, an LED emitting blue light is preferably employed. For example, an LED having a primary emission peak wavelength of at most 500 nm, more specifically, an LED employing a nitride semiconductor such as GaN or InGaN, or a group II-VI compound semiconductor such as ZnO or ZnS, may be employed.

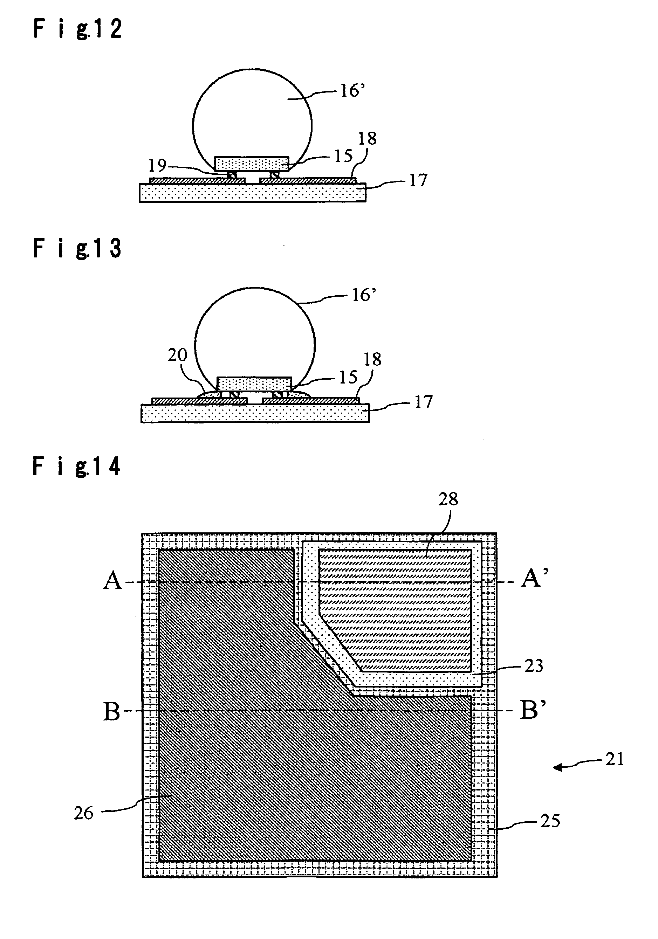

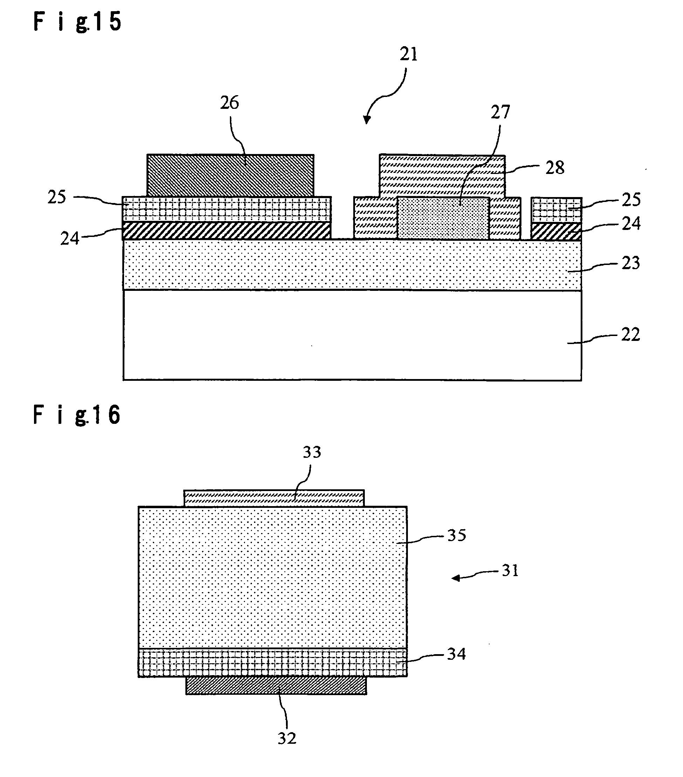

Fig. 14 is an example of a plane view of an LED applicable to this embodiment. Further, Fig. 16 is a cross-sectional view along a line A-A' of Fig. 14. In these Figures, LED 21 has a substrate 22, a n-layer 23, an i-layer 24 being a light-emitting layer, a p-layer 25 and a p-type electrode 26 formed in this layer on the substrate 22. Further, on the substrate 22, an n-layer 27 and an n-type electrode 28 are formed in this order. In this case, since no i-layer 24 is formed under the n-type electrode 28, light is not observed from this portion. Here, when the LED 21 is applied to Fig. 2, Fig. 2 is considered to be a cross-sectional view along a B-B' line of Fig. 14.

Further, Fig. 16 is another example of cross-sectional view of a LED applicable to this embodiment. In Fig. 16, an LED 31 has a structure that between a p-type electrode 32 and an n-type electrode 33, a semiconductor layer 34 constituted by a p-layer, an i-layer and an n-layer, and an electrically conductive SiC substrate 35 are sandwiched. According to this structure, light can be extracted from entire surface of the substrate, and accordingly, no-emission portion such as those of Figs. 14 and 15 is not formed.

Here, the light-emitting device of the present invention is applicable to a case where the light-emitting element is a semiconductor laser instead of LED. As the semiconductor laser, one that is not deteriorated by heat treatment at the time of sealing with glass is employed in the same manner as LED. Namely, a semiconductor laser having a main emission peak wavelength of at most 500 nm, more specifically, a semiconductor laser employing a nitride semiconductor such as GaN or InGaN or a Group II-VI compound semiconductor such as ZnO or ZnS, may be employed.

As the wiring board 17, a heat resistant substrate is preferably employed. This is because the wiring board 17 is to be heated to a melting temperature of the glass member 16 when the LED 15 is sealed with the glass member 16. For this reason, a resin substrate made of e.g. an epoxy resin is not preferred since it may undergo thermal deterioration. A heat-resistant substrate applicable to this embodiment may, for example, be a ceramic substrate such as an alumina substrate, an aluminum nitride substrate or a silicon carbide substrate, a glass ceramic substrate or a silicon substrate having a surface on which a silicon oxide film is formed (silica-coated silicon substrate).

A material forming an electrode (not shown) of LED 15 or the wiring 18 may, for example, be gold (Au), platinum (Pt), silver (Ag) or aluminum (Al). Among these, from the viewpoint of high melting point and difficulty of oxidization, gold is preferably employed. Here, in a semiconductor device such as LED, for example, an electrode having a layer structure having improved heat resistance by using a predetermined material disclosed in e.g. JP-A-2002-151737, JP-A-10-303407 or JP-A-2005-136415, may be applied. This is advantageous because when the LED 15 is covered with a glass member 16, the LED 15 is subjected to a heat treatment at a high temperature in the atmospheric air and it is necessary to prevent the electrode or the wiring 18 from being deformed or oxidized by heat. For the same reason, for the material of bumps 19, gold is preferably employed. Here, when electric current is applied under high temperature-high humidity conditions, there occurs no problem when the electrode, the bumps 19 and the wirings 18 are all made of gold, but corrosion may occur when different type of metals are employed.

Then, as shown in Fig. 10, the glass member 16 is placed on the LED 15, and the glass member 16 is melted by heat. The heating temperature has to be a temperature capable of melting the glass member. This temperature is determined according to the composition of glass member 16. For example, when the glass member 16 employed is composed of $TeO_2$ (45.0 mol%), $TiO_2$ (1.0 mol%), $GeO_2$ (5.0 mol%), $B_2O_3$ (18.0 mol%), $Ga_2O_3$ (6.0 mol%), $Bi_2O_3$ (3.0 mol%), ZnO (15 mol%), $Y_2O_3$ (0.5 mol%), $La_2O_3$ (0.5 mol%), $Gd_2O_3$ (3.0 mol%) and $Ta_2O_5$ (3.0 mol%), the heating temperature is set to be at least 500°C, preferably at least 570°C.

Further, the heating temperature needs to be a temperature lower than the temperature causing trouble of operation function of LED 15.

Specifically, the heating temperature is preferably at most 700°C, more preferably at most 630°C. When the temperature exceeds 700°C, the light-emitting function of LED 15 may be impaired.

In this embodiment, the heating treatment may be carried out by using infrared rays or by using an electric furnace. In the case of using infrared rays, it becomes possible to shorten treatment time as compared with a case of employing an electric furnace, and thus, it becomes possible to improve productivity of light-emitting device. On the other hand, in a case of using an electric furnace, it is possible to uniformly raise the temperatures of glass member and light-emitting element.

Fig. 17 is an example of comparison of temperature profiles of these methods. Here, in this example, an electric furnace (product name: FP41) manufactured by Yamato Scientific Co., Ltd. or an infrared heating apparatus IVF298W (product name) manufactured by Thermo Riko Co., Ltd. was employed.

In the case of using an electric furnace, as shown in the broken line in Fig. 17, the temperature was raised from a room temperature to 610°C in 60 min, it was maintained at 610°C for 15 min, and lowered to the room temperature in at least 4 hours. On the other hand, in a case of using infrared rays, as shown in the solid line in Fig. 17, the temperature was raised from a room temperature to 630°C in 15 min, it was maintained at 630°C for 1 min, and it was lowered to the room temperature in 5 min. Thus, by using infrared rays, as compared with a case of employing an electric furnace, it becomes possible to shorten temperature-raising time and temperature-lowering time.

When the glass member 16 is heated by a heating treatment, as shown in Fig. 11, the glass member 16 tries to form a shape (spherical shape) determined by its surface energy and the wettability of LED 15 at a certain temperature. However, actually, deformation due to its own weight is added to such a shape, and a final shape shown in Fig. 12, that is, a shape obtained in a equilibrium state, is determined. In this case, as the weight of glass member 16 is smaller, its surface shape becomes close to a sphere, but as the weight of glass member 16 is larger, its surface shape becomes close to oblate shape.

During the process from Fig. 10 to Fig. 12, the LED 15 is covered with the glass member 16. In this process, employment of e.g. a mold is not required.

In Fig. 12, a curved face of the glass 16' contacts with side faces of the LED 15, and the ratio (b/a) of protrusion of glass from the electrode face becomes substantially 0. Further, the rotational axis of the glass 16' agrees with the rotational axis of LED 15. Such a shape is formed in self-alignment manner from molten glass member 16. From now, this self-alignment process is described in more detail.

When a glass member is softened on a LED, the glass member behaves as if it flows out downwardly from the upper face of the LED. In the following, an example of change of glass member after it is melted is shown. For example, the glass member is not necessarily flows out isotropically, but unevenness tends to occur depending on the shape of glass member or the position on which the glass member is placed. Then, when a glass member at first starts to flow out from one side of a LED, the glass member flown out downwardly along a side wall of the LED, and stops at the lower end of the side wall. Subsequently, glass member flown out from other sides also stop at the lower ends of the side walls in the same manner. At this time, when the amounts of glass member flown out from the respective sides are different, the glass member moves so as to entirely balance the glass member. Then, the glass member is stabilized at a position where the rotational axis of the glass member agrees with the rotational axis of LED to form a stable shape. Accordingly, even without carrying out position alignment of glass member to LED before heating, the shape of Fig. 12 is obtainable in a self-alignment manner. Thereafter, by lowering the temperature, the shape can be solidified.

Here, since the viscosity of glass member changes depending on the temperature, when the temperature changes according to time, the viscosity of glass member changes according to time. Accordingly, when a retention time at a certain temperature is shorter than a time required for deformation of glass member, the shape of glass is determined before the shape reaches to a shape obtainable in an equilibrium state. For this reason, in order to obtain the above shape by a self-alignment process, it is preferred to retain a molten glass member in a state of appropriate viscosity. Specifically, the glass member is preferably retained at a glass-transition point (from 100°C to 200°C, preferably from 120°C to 200°C).

Further, in order to obtain the shape of Fig. 12 by a self-alignment process, the size of glass is preferably smaller when the size of LED is constant. For example, when a LED having an electrode face of 320 $\mu$m square wherein L/2=226 $\mu$m, is employed, in each of cases where the diameters of glasses are 0.35 mm, 0.64 mm, 0.74 mm and 1.04 mm respectively, it was possible to cover the LED with a glass having a shape equivalent to that of Fig. 12. However, when the diameter of glass was 1.4 mm, softened glass did not stop at the lower end of the side walls of LED and contacted with a wiring board, and thus, the shape of Fig. 12 could not be obtained.

The light-emitting device of this embodiment can be obtained by the above-described process.

Here, the present invention is not limited to the above embodiment, but the present invention can be worked with various modifications within a range not departing from the gist of the present invention.

For example, in this embodiment, as shown in Fig. 13, a sealing resin 20 is preferably provided between the glass 16' or LED 15 and the wiring board 17. By this method, it is possible to prevent moisture from penetrating from the outside through a gap between these members. Further, since the glass 16' is supported by the sealing resin 20, it becomes possible to stably retain the glass 16'. For this purpose, the sealing resin 20 is preferably one having low moisture-absorption property and at least a certain extent of mechanical strength. Here, the sealing resin 20 may be any one of UV-curable type and a thermosetting type (for example, an acrylic resin or an epoxy resin), but from the viewpoint of high curing speed or low impact on members around the resin, a resin of UV-curable type is preferably employed.

INDUSTRIAL APPLICABILITY

The light-emitting device of the present invention is applicable to various types of applications such as light-emitting diodes to be employed for LED displays, backlight light sources, in-vehicle light sources, traffic lights, optical sensors, indicators, fish attraction lamps, automobile head lamps, turn signal lamps or hazard lamps; or to optical pickups.

The entire disclosure of Japanese Patent Application No. 2006-119668 filed on April 24, 2006 including specification, claims, drawings and summary is incorporated herein by reference in its entirety.

**Claims**

1. A light-emitting device comprising a wiring board, a light-emitting element electrically connected with the wiring board and a glass covering the light-emitting element, wherein entirety of the glass is substantially spherical, the light-emitting element is embedded in a part of the glass, and a curved surface of the glass contacts with a side face of the light-emitting element.

2. A light-emitting device comprising a wiring board, a light-emitting element electrically connected with the wiring board and a glass covering the light-emitting element, wherein the glass has a portion having a curved surface and a flat portion in terms of surface shape, a surface of the light-emitting element opposite to the wiring board and the flat portion of the glass substantially share the same plane, and provided that a length from the center to the end of the plane facing to the wiring board is designated as "a" and the length from the end of the plane to the outer periphery of the flat portion is designated as "b", a relation

$$0 < (b/a) \leqq 0.2$$

is satisfied.

3. The light-emitting device according to Claim 2, wherein when the refractive index of the glass is at most 1.6, a relation

$$0 < (b/a) \leqq 0.1$$

is satisfied.

4. The light-emitting device according to Claim 2 or 3, wherein the curved surface is a part of a spherical surface.

5. The light-emitting device according to any one of Claims 1 to 4, wherein the entirety of the glass is substantially spherical shape, and the dimension of the substantially spherical shape along the principal axis in the horizontal direction is at most 1.5 mm.

6. The light-emitting device according to any one of Claims 1 to 5, wherein the light-emitting element is a polygonal semiconductor chip having a center of rotation in the plan view.

7. The light-emitting device according to any one of Claims 1 to 6, wherein the light-emitting element is an LED or a semiconductor laser.

8. The light-emitting device according to any one of Claims 1 to 7, wherein the glass contains $TeO_2$, $B_2O_3$ and ZnO as main components.

**F i g.1**

**F i g.2**

F i g.3

$\underset{\sim}{1}$

F i g.4

F i g.5

F i g.6

## F i g.7

## F i g.8

F i g.9

F i g.10

F i g.11

**F i g.12**

**F i g.13**

**F i g.14**

F i g.15

F i g.16

F i g.17

F i g.18

## INTERNATIONAL SEARCH REPORT

International application No.

PCT/JP2007/058862

### A. CLASSIFICATION OF SUBJECT MATTER
*H01L33/00* (2006.01)i

According to International Patent Classification (IPC) or to both national classification and IPC

### B. FIELDS SEARCHED

Minimum documentation searched (classification system followed by classification symbols)
H01L33/00

Documentation searched other than minimum documentation to the extent that such documents are included in the fields searched

| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2003-017756 A (Toyoda Gosei Co., Ltd.), 17 January, 2003 (17.01.03), Full text; all drawings (Family: none) | 1-7 |
| A | JP 2002-176200 A (LumiLeds Lighting U.S., LLC), 21 June, 2002 (21.06.02), Full text; all drawings & US 2002/0030194 A1 & EP 1191608 A2 | 1-7 |
| A | JP 2002-305328 A (Nichia Chemical Industries, Ltd.), 18 October, 2002 (18.10.02), Full text; all drawings (Family: none) | 1-7 |

☒ Further documents are listed in the continuation of Box C.　　☐ See patent family annex.

| | |
|---|---|
| *　　Special categories of cited documents: | "T"　later document published after the international filing date or priority date and not in conflict with the application but cited to understand the principle or theory underlying the invention |
| "A"　document defining the general state of the art which is not considered　to be of particular relevance | |
| "E"　earlier application or patent but published on or after the international filing date | "X"　document of particular relevance; the claimed invention cannot be considered novel or cannot be considered to involve an inventive step when the document is taken alone |
| "L"　document which may throw doubts on priority claim(s) or which is cited to establish the publication date of another citation or other special reason (as specified) | "Y"　document of particular relevance; the claimed invention cannot be considered to involve an inventive step when the document is combined with one or more other such documents, such combination being obvious to a person skilled in the art |
| "O"　document referring to an oral disclosure, use, exhibition or other means | |
| "P"　document published prior to the international filing date but later than the priority date claimed | "&"　document member of the same patent family |

| Date of the actual completion of the international search | Date of mailing of the international search report |
|---|---|
| 16 May, 2007 (16.05.07) | 29 May, 2007 (29.05.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

## INTERNATIONAL SEARCH REPORT

| International application No. |
| --- |
| PCT/JP2007/058862 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2004-253638 A  (Matsushita Electric Industrial Co., Ltd.), 09 September, 2004 (09.09.04), Full text; all drawings (Family: none) | 1-7 |
| A | WO 2004/100279 A2  (CREE INC.), 18 November, 2004 (18.11.04), Full text; all drawings & US 2004/0227149 A1    & EP 1620903 A2 & JP 2006-525682 A | 1-7 |
| A | JP 2005-057266 A  (LumiLeds Lighting U.S., LLC), 03 March, 2005 (03.03.05), Full text; all drawings & EP 1503434 A2           & US 2005/0023545 A1 | 1-7 |

Form PCT/ISA/210 (continuation of second sheet) (April 2005)

## REFERENCES CITED IN THE DESCRIPTION

**Patent documents cited in the description**

- JP 8102553 A
- WO 2004082036 A
- JP 2006111089 A
- JP 2006072612 A
- JP 2002151737 A
- JP 10303407 A
- JP 2005136415 A
- JP 2006119668 A